# EUROPEAN PATENT APPLICATION

(11) **EP 4 535 940 A1**
(43) Date of publication of application: **09.04.2025**
(21) Application number: 23901986.2
(22) Date of filing: 24.04.2023
(51) Int. Cl.: H05K 5/00

(54) **ELECTRIC DRIVE CONTROLLER, ELECTRIC DRIVE SYSTEM, AND AUTOMOBILE**

(30) Priority: 12.12.2022 CN 202211616180
(71) Applicant: Zhejiang Leappower Technology Co., Ltd, Hangzhou, Zhejiang 310000 (CN); Zhejiang Leapmotor Technology Co., Ltd, Hangzhou, Zhejiang 310051 (CN)
(72) Inventor: XIE, Wei, Hangzhou, Zhejiang 311000 (CN); YANG, Zhichao, Hangzhou, Zhejiang 311000 (CN); LIAO, Yang, Hangzhou, Zhejiang 311000 (CN); SHAN, Dongsheng, Hangzhou, Zhejiang 311000 (CN); WANG, Chenlin, Hangzhou, Zhejiang 311000 (CN); XU, Lingyang, Hangzhou, Zhejiang 311000 (CN)
(74) Representative: Herrero & Asociados, S.L.
(86) International application number: PCT/CN2023/090392
(87) International publication number: WO 2024/124773

(57) **Abstract**

The present application provides an electric drive controller, an electric drive system, and an automobile. The electric drive controller comprises a controller box and electronic components arranged in the controller box. Additionally, the controller box comprises a closed cavity and insertion holes which are communicated with each other, and a cover covering the closed cavity; the closed cavity is located in the controller box and isolated from other space in the controller box, so as to accommodate a component needing to be disassembled, assembled, connected or replaced, without influencing electronic components arranged in other parts in the controller box. The electronic components comprise a high-voltage bus piercing connector, the high-volage bus piercing connector comprises interface end portions, and the high-voltage bus piercing connector and the interface end portions are respectively accommodated in the closed cavity and the insertion holes. Thus, during bus disassembly and assembly, because the high-voltage bus piercing connector is accommodated in the closed cavity and is isolated from the space, in which other electronic components are arranged, in the controller box, moisture or other foreign matters can be prevented from entering the controller box and influencing normal operation of the other electronic components.

## Description

### TECHNICAL FIELD

Embodiments of the present disclosure relate to the technical field of vehicle accessories, and more specifically, to an electric drive controller, an electric drive system, and a vehicle.

### BACKGROUND

The electric drive controller is one of essential components of an electric vehicle. The electric drive controller converts electric energy stored in a power battery into electric energy for a drive motor based on a gear instruction, a throttle instruction, a brake instruction, and other instructions, so as to control an operation state of the electric vehicle, such as activation and operation, a speed of forward and reversing running, a strength of climbing a slop; or to assist the electric vehicle to brake and store a part of braking energy into the power battery.

The electric drive controller includes a high-voltage bus perforation connector. The high-voltage bus perforation connector is connected to other components of the vehicle, such as a battery pack, via a direct-current bus connector. In most of cases, the direct-current bus connector is connected in a perforated manner. However, the bus mounted in this way has poor sealing and isolation performance at a mounting position. In addition, when the electric drive controller is being inspected and repaired, the high-voltage bus perforation connector needs to be inspected separately. Therefore, when the high-voltage bus perforation connector needs to be replaced during the inspection, water vapor or dust inside or outside the electric drive controller may pass through a perforation of the high-voltage bus perforation connector to reach the other components of the electric drive controller or other components of the vehicle connected to the electric drive controller. In this way, the electric drive controller or electronic components of the vehicle may be malfunctioned, affecting use of the electric drive controller.

### SUMMARY

The present disclosure provides an electric drive controller, an electric drive system, and a vehicle to solve a technical problem that a positive-electrode mounting cavity and a negative-electrode mounting cavity of a bus perforation connector of the electric drive controller are communicated with an internal cavity of the electric drive controller, and the bus perforation connector has poor isolation performance at a mounting position.

In an aspect, the present disclosure provides an electric drive controller, including a controller box and electronic components arranged in the controller box. The controller box includes a closed cavity, a plug-connection hole and a cover body covering the closed cavity; the plug-connection hole is communicated with the closed cavity. The electronic components comprise a high-voltage bus perforation connector, the high-voltage bus perforation connector comprises an interface end portion. The high-voltage bus perforation connector is received in the closed cavity, and the interface end portion is received in the plug-connection hole.

In some embodiments, the controller box further includes a receiving cavity, a connection hole and an isolation plate. The receiving cavity and the closed cavity are communicated with each other via the connection hole, the isolation plate covers the connection hole, and the isolation plate defines a wire through hole. The electronic components further comprise a filter assembly and a circuit board, the circuit board is received in the receiving cavity; the filter assembly is received in the receiving cavity and connected to the high-voltage bus perforation connector. The filter assembly comprises a connection end portion, the connection end portion is arranged within the wire through hole and connected to the circuit board.

In some embodiments, an isolation sealing ring is arranged in the connection hole. The isolation plate is mounted in the connection hole, the isolation sealing ring sleeves peripheral end edges of the isolation plate and abuts against a wall of the connection hole and the peripheral end edges of the isolation plate.

In some embodiments, the controller box is arranged with a stop step formed at a connection position where the connection hole and the closed cavity are connected to each other. The isolation plate is fixed to the stop step and covers the connection hole.

In some embodiments, the controller box is arranged with another stop step at a connection position where the connection hole and the receiving cavity are connected to each other. An isolation sealing ring is arranged in the connection hole. The isolation plate comprises a first sub-plate and a second sub-plate, the first sub-plate is fixed to the stop step, the second sub-plate is fixed to the another stop step. The isolation sealing ring is disposed between and abuts against the first sub-plate and the second sub-plate.

In some embodiments, the filter assembly further includes a housing, the connection end portion is formed by extending from the housing. The isolation plate is a fixed flange protruding from the housing.

In some embodiments, the circuit board is arranged with a control module circuit area and a drive module circuit area. The circuit board defines a plurality of fixation holes at a periphery of the circuit board, and the circuit board is fixedly arranged in the receiving cavity through the plurality of fixation holes.

In some embodiments, the controller box includes a box body and a box cover covering to the box body. The closed cavity and the receiving cavity are both defined in the box body, the box cover defines a disassembling opening at a position corresponding to the closed cavity, the cover body covers the disassembling opening. The circuit board is further arranged with an interface circuit area and an electrically conductive frame surrounding the interface circuit area. The box cover further defines an isolation cavity at a position corresponding to the receiving cavity, the interface circuit area is disposed in the isolation cavity, and an end surface of the isolation cavity abuts against the electrically conductive frame.

In some embodiments, an electrically conductive rubber ring is disposed between the isolation cavity and the electrically conductive frame. The electrically conductive rubber ring abuts against the end surface of the isolation cavity and the electrically conductive frame. Each of the electrically conductive frame and the electrically conductive rubber ring is a closed frame structure where a head and an end of the frame structure are connected to each other. The electrically conductive frame, the electrically conductive rubber ring and the isolation cavity have a same cross-sectional cavity shape along a direction perpendicular to a depth direction of the isolation cavity.

In some embodiments, the electric drive controller further includes a plug-connection member and a fixation member. The plug-connection member comprises a soldering pin, the soldering pin is soldered and fixed to the circuit board and connected to the interface circuit area. The fixation member extends along a first direction to extend through the fixation hole to fix the circuit board in the box body. The plug-connection member further comprises a plug-connection end disposed opposite to the soldering fin, and at least part of the plug-connection end extends to be exposed out of the box body.

In some embodiments, the controller box includes a box body and a box cover covering to the box body. The box cover defines a disassembling opening at a position corresponding to the closed cavity, the box cover covers the disassembling opening. The box cover is arranged with a tab protruding from the box cover, the tab is mated with the disassembling opening, the tab is received in the disassembling opening. A sealing ring is arranged to sleeve an outer wall of the tab, the sealing ring is disposed between the tab and an inner wall of the disassembling opening.

In another aspect, the present disclosure provides an electric drive system, including a drive motor and the electric drive controller as described in the above. The drive motor is connected to the electric drive controller.

In some embodiments, the electric drive controller includes a three-phase wire copper row arranged in the controller box, the three-phase wire copper row includes a connection end exposed out of the controller box. The drive motor comprises a motor housing and a motor terminal exposed from the motor housing. The controller box and the motor housing support each other, and the connection end is connected with the motor terminal. A blocking member is received in a gap path defined between the controller box and the motor housing, and the gap path extends along a direction from a connection point where the connection end and the motor terminal are connected to each other towards an exterior of the electric drive system.

In some embodiments, each of the controller box and the motor housing comprises a respective support surface, the support surface of the controller box and the support surface of the motor housing support each other. The connection end protrudes from the support surface of the controller box to be exposed out of the controller box. The support surface of the controller box is arranged with a protrusion; the support surface of the motor housing defines a recess, the protrusion is received in the recess.

In still another aspect, the present disclosure provides a vehicle, including a battery pack, a high-voltage bus line, and the electric drive controller as described in the above. The high-voltage bus line is connected to the battery pack and the interface end portion.

According to the present disclosure, the electric drive controller includes a controller box and electronic components arranged inside the controller box. The controller box includes a closed cavity, a plug-connection hole communicated with the closed cavity, and a cover body covering and sealing the closed cavity. The closed cavity is located inside the controller box and isolated from other portions of the controller box. The closed cavity receives components that need to be detached and assembled for connection or need to be replaced, and detaching, assembling and replacing the components may not interfere with electronic components disposed at other portions of the controller box. Further, the above-described electronic components include a high-voltage bus perforation connector. The high-voltage bus perforation connector includes an interface end portion to be connected to other electronic components. In order to prevent water vapor or other foreign matter from entering, during assembling in an assembling workshop or during after-sale disassembling a bus line to replace the electric drive controller, the controller box to further avoid affecting normal operation of other electronic components, the high-voltage bus perforation connector is received in the closed cavity, and the interface end portion is received in the plug-connection hole. In this way, when detaching and assembling the bus line, since the high-voltage bus perforation connector is received in the closed cavity, the high-voltage bus perforation connector is separated from a space in which other electronic components are arranged in the controller box, the water vapor or the other foreign matter are prevented from entering the controller box and affecting normal operation of the other electronic components.

### BRIEF DESCRIPTION OF THE DRAWINGS

In order to more clearly illustrate technical solutions in embodiments of the present disclosure, the accompanying drawings used for describing the embodiments will be briefly introduced below. Obviously, the accompanying drawings in the following description are only some of the embodiments of the present disclosure, and any ordinary skilled person in the art may obtain other accompanying drawings according to these drawings without making any creative work.
FIG. 1 is an exploded view of an electric drive controller according to an embodiment of the present disclosure.
FIG. 2 is an exploded view of the electric drive controller shown in FIG. 1, being viewed from another viewing angle.
FIG. 3 is an enlarged view of a partial structure of the electric drive controller shown in FIG. 1.
FIG. 4 is a top view of the partial structure of the electric drive controller shown in FIG. 3.
FIG. 5 is a structural schematic view of an electric drive system according to an embodiment of the present disclosure, where the electric drive system includes a drive motor and an electric drive controller.
FIG. 6 is a cross-sectional view of the electric drive system shown in FIG. 5, taken along a line B-B.

### DETAILED DESCRIPTIONS

The technical solutions in the embodiments of the present disclosure will be described clearly and completely in the following by referring to the accompanying drawings in the embodiments of the present disclosure. Obviously, the described embodiments are only a part of, not all of, the embodiments of the present disclosure. All other embodiments, which are obtained by any ordinary skilled person in the art based on the embodiments in the present disclosure without any creative work, shall fall within the scope of the present disclosure.

In the description of the embodiments of the present disclosure, to be noted that, unless otherwise expressly provided and limited, terms "interconnected" and "connected" shall be broadly interpreted. For example, connection may be fixed connection, detachable connection, or components being connected to form a one-piece structure; or the connection may be mechanical connection, or electrical connection. The connection may be direct connection or indirect connection through an intermediate medium. For any ordinary skilled person in the art, a specific meaning of the above terms in the embodiments of the present disclosure may be interpreted case by case.

In the embodiments of the present disclosure, unless otherwise expressly provided and limited, a first feature being "above" or "below" a second feature may indicate that the first feature directly contacts the second feature, the first feature indirectly contacts the second feature via an intermediate medium. In addition, the first feature being "above", "on" and "on top of" the second feature may indicate that the first feature is directly above or diagonally above the second feature, or the first feature is horizontally higher than the second feature. The first feature being "below", "under" and "beneath" the second feature may indicate that the first feature is directly below or diagonally below the second feature, or the first feature is horizontally lower than the second feature.

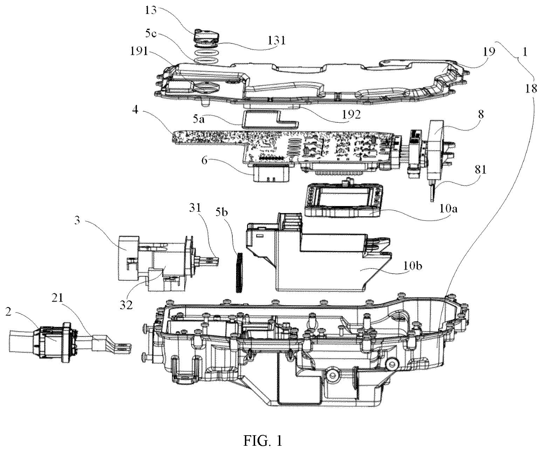

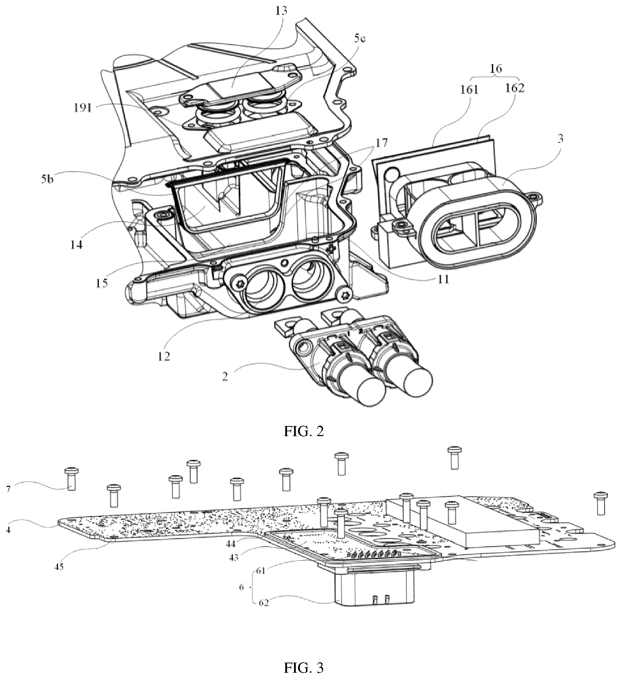

As shown in FIGS. 1 and 2, FIG. 1 is an exploded view of an electric drive controller according to an embodiment of the present disclosure; and FIG. 2 is an exploded view of the electric drive controller shown in FIG. 1, being viewed from another viewing angle. In an aspect, the present disclosure provides an electric drive controller. In an embodiment, the electric drive controller includes a controller box 1 and electronic components disposed inside the controller box 1. The controller box 1 includes a closed cavity 11, a plug-connection hole 12 communicated with the closed cavity 11, and a cover body 13 covering and sealing the closed cavity 11. The closed cavity 11 is defined inside the controller box 1 and isolated from other components in the controller box 1. The above-described electronic components include a high-voltage bus perforation connector 2. The high-voltage bus perforation connector 2 includes an interface end portion 21 to be connected with other electronic components. In order to prevent water vapor or other foreign matter from entering, during assembling in an assembling workshop or during after-sale detaching a bus line to replace the electric drive controller, the controller box 1 to further avoid affecting normal operation of the other electronic components, the high-voltage bus perforation connector 2 is received in the closed cavity 11 and the interface end portion 21 is received in the plug-connection hole 12. In this way, when the bus line is detached and assembled, since the high-voltage bus perforation connector 2 is received in the closed cavity 11 and is separated from a space in the controller box 1 in which the other electronic components are received, the water vapor or the other foreign matter are prevented from entering the controller box 1, such that normal operation of the other electronic components may not be affected.

It is understood that other electronic components of the electric drive controller that need to be detached and assembled for connection or need to be replaced may also be received in a separated closed cavity 11, similar to the case of the high-voltage bus perforation connector 2. In this way, the other electronic components of the controller box 1 may not be affected by during disassembling or replacing.

Specifically, the controller box 1 further includes a receiving cavity 14, a connection hole 15, and an isolation plate 16. The receiving cavity 14 is communicated with the closed cavity 11 via the connection hole 15. The isolation plate 16 covers the connection hole 15. In addition, in order to enable electronic components received in the receiving cavity 14 to be connected with the electronic components received in the closed cavity 11. The isolation plate 16 defines a wire through hole (not shown in the drawing). In addition, the electronic components further include a filter assembly 3 and a circuit board 4. The circuit board 4 is received in the receiving cavity 14. The filter assembly 3 is configured to reduce signals of a frequency different from a frequency of the electric drive controller to eliminate an effect caused by noise. Further, the filter assembly 3 is received in the closed cavity 11 and is connected to the high-voltage bus perforation connector 2. In order to enable the filter assembly to be easily connected to other components, the filter assembly 3 includes a connection end portion 31, and the connection end portion 31 is mounted in the wire through-hole and connected to the circuit board 4.

More specifically, in an embodiment, in order to enable the isolation plate 16 to cover the connection hole 15 more tightly, an isolation sealing ring 5b is received in the connection hole 15, and the isolation plate 16 is mounted in the connection hole 15. The isolation sealing ring 5b sleeves peripheral end edges of the isolation plate 16 and abuts against a hole wall of the connection hole 15 and the peripheral end edges of the isolation plate 16. Understandably, the isolation sealing ring 5b has certain elasticity and can withstand certain compression. During assembling, the isolation sealing ring 5b is disposed at the peripheral end edges of the isolation plate 16, and the isolation plate 16 is mounted inside the connection hole 15. In this way, the isolation sealing ring 5b abuts against the hole wall of the connection hole 15 and the peripheral end edges of the isolation plate 16, enabling the isolation plate 16 to cover and seal the connection hole 15 more tightly.

In order to securely fix the isolation plate 16 inside the controller box 1, the controller box 1 is arranged with a stop step 17 at a connection point where the connection hole 15 and the closed cavity 11 are connected to each other. During assembling, the isolation plate 16 is fixed to the stop step 17 and covers the connection hole 15.

Specifically, in an embodiment, the controller box 1 is further arranged with another stop step 17 at a connection point where the connection hole 15 and the receiving cavity 14 are connected to each other. The isolation plate 16 includes a first sub-plate 161 and a second sub-plate 162. The first sub-panel 161 is fixed to the another stop step 17, and the second sub-panel 162 is fixed to the stop step 17. That is, each of the connection point where the connection hole 15 is connected to the closed cavity 11 and the connection point where the connection hole 15 is connected to the receiving cavity 14 is arranged with one stop step 17, and the stop step 17 and the another stop step 17 are connected to each other. During assembling, the first sub-panel 161 is fixed to the another stop step 17, and the second sub-panel 162 is fixed to the stop step 17, and the isolation sealing ring 5b is disposed between the first sub-plate 161 and the second sub-plate 162 to abut against the first sub-plate 161 and the second sub-plate 162, such that covering performance that the isolation plate covers the closed cavity 11 is improved.

In an embodiment, the filter assembly 3 further includes a housing 32, and the connection end portion 31 is formed by extending from the housing 32. That is, the connection end portion 31 is connected with the housing 32, and the connection end portion 31 is a part of the housing 32. Moreover, the above-mentioned isolation plate 16 is a fixed flange protruding from the housing 32 to enable the filter assembly 3 to be connected to a flange of another component corresponding to the fixed flange. It is understood that the isolation plate 16 is connected with the housing 32, and the isolation plate 16 is formed by protruding from the housing 32. Of course, in some embodiments, the isolation plate 16 may be a structure separated from the housing 32.

As shown in FIG. 1, more specifically, the controller box 1 includes a box body 18 and a box cover 19 covering the box body 18. It is understood that the closed cavity 11 and the receiving cavity 14 are both defined in the box body 18. The closed cavity 11 and the receiving cavity 14 are closed and isolated from each other by the isolation plate 16. Moreover, in order to disassemble the electronic components in the closed cavity 11 to be repaired or replaced, the box cover 19 defines a disassembling opening 191 corresponding to a location where the closed cavity 11 is arranged. The cover body 13 covers the disassembling opening 191 to cover the closed cavity 11 to prevent the electronic components in the closed cavity 11 from being damaged by external foreign matter entering the closed cavity 11. That is, the cover body 13, after covering the disassembling opening 191, is disposed on a wall of the box cover 19 and is connected to the box cover 19.

Further, a tab 131 is formed by protruding from the cover body 13 to be mated with the disassembling opening 191. During assembling, the tab 131 is received in the disassembling opening 191. The cover body 13 is mounted to the box cover 19 through mating between the disassembling opening 191 and the tab 131. Moreover, in order to enable the cover body 13 to be more tightly mounted to the box cover 19, an outer wall of the tab 131 is sleeved by a sealing ring 5c. The sealing ring 5c has certain elasticity and can withstand certain compression. The sealing ring 5c is mounted between the tab 131 and an inner wall of the disassembling opening 191, such that a gap between the outer wall of the tab 131 and the inner wall of the disassembling opening 191 is filled.

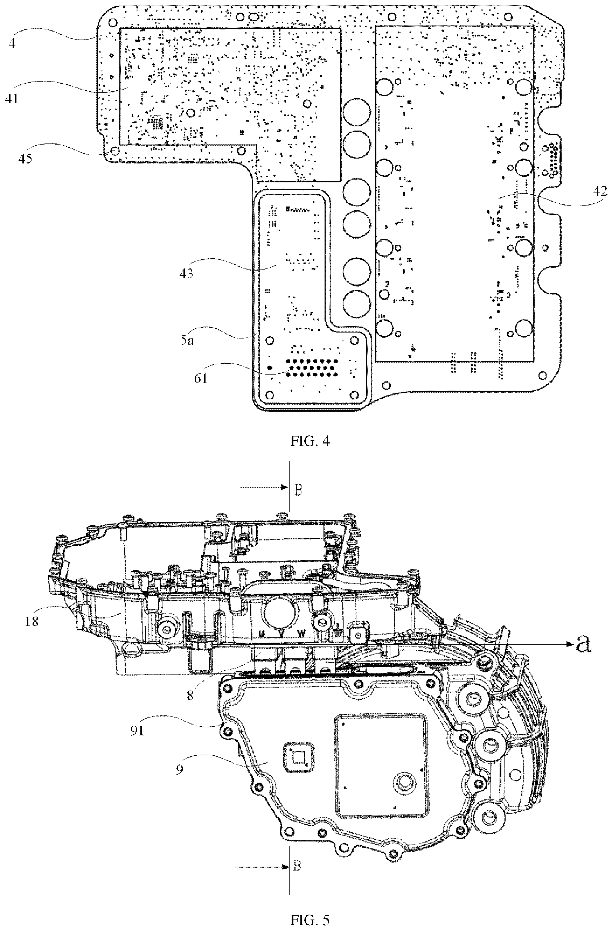

As shown in FIG. 3 and FIG. 4, FIG. 3 is an enlarged view of a partial structure of the electric drive controller shown in FIG. 1; and FIG. 4 is a top view of the partial structure of the electric drive controller shown in FIG. 3. In an embodiment, the circuit board 4 is arranged with a control module circuit area 41 and a drive module circuit area 42. The control module circuit area 41 is configured to achieve a controlling function of the electric drive controller, and the drive module circuit area 42 is configured to achieve a driving function of the electric drive controller. In addition, the circuit board 4 defines a plurality of fixation holes 45 located at a periphery of the circuit board 4. The circuit board 4 is fixedly arranged in the receiving cavity 14 via the plurality of fixation holes 45. The plurality of fixation holes 45 may be mated with bolts or fixation blocks to mount the circuit board in the controller box 1.

The circuit board 4 is further arranged with an interface circuit area 43 and an electrically conductive frame 44 surrounding the interface circuit area 43. The box cover 19 defines an isolation cavity 192 at a position corresponding to the receiving cavity 14. The interface circuit area 43 is disposed in the isolation cavity 192. An end surface of the isolation cavity 192 abuts against the electrically conductive frame 44. Understandably, when assembling the electric drive controller is completed, i.e., when the case body 18 and the case cover 19 are fixedly connected to each other, the interface circuit area 43 is disposed within the isolation cavity 192, and the end surface of the isolation cavity 192 abuts against the electrically conductive frame 44. Since the end surface of the isolation cavity 192 abuts against the electrically conductive frame 44, conductive connection between the controller box 1 and the circuit board 4 is achieved to be grounded. In addition, the interface circuit area 43 is disposed in the isolation cavity 192, the isolation cavity 192 blocks transmission of voltage signals, preventing the control module circuit area 41 and the drive module circuit area 42 from interfering conduction of the interface circuit area 43, it is ensured that signals are not interfered, and the electric drive controller can communicate with the entire vehicle normally. The box cover 19 defines the isolation cavity 192, and the interface circuit area 43 is disposed in the isolation cavity 192 and is tightly compressed by and sealed by the electrically conductive frame 44 via the box cover 19. In addition, the isolation cavity 192 forms a closed shielding space, such that the shielding achieves external radiation interference.

In addition, an electrically conductive rubber ring 5a is disposed between the isolation cavity 192 and the electrically conductive frame 44. The electrically conductive rubber ring 5a abuts against the electrically conductive frame 44 and the end surface of the isolation cavity 192. Understandably, when the box cover 19 and the box body 18 are fixedly connected to each other, the electrically conductive frame 44 on the circuit board 4 and the electrically conductive rubber ring 5a contact and abut against each other. On the one hand, since the electrically conductive rubber ring 5a has certain elasticity, the electrically conductive rubber ring 5a can withstand certain compression, ensuring that the box cover 19 and the electrically conductive frame 44 are tightly connected to each other without defining any gap therebetween, and improving reliability of electrical conduction. On the other hand, the circuit board 4 and the box cover 19 are connected to each other through the electrically conductive frame 44 and the electrically conductive rubber ring 5a, and therefore, the controller box 1 is electrically connected with the circuit board 4 to be grounded, such that electricity leakage is reduced, and human electrocution due to the electricity leakage is reduced. The above-mentioned electrically conductive rubber ring 5a is a frame-shaped structure made of electrically conductive rubber that is available in the market. Further, in order to form better sealing and electrically conductive performance and to facilitate processing and manufacturing, each of the electrically conductive frame 44 and the electrically conductive rubber ring 5a is a closed frame structure where a head and an end are connected to each other. In this way, a gap, which may result in interruption in current conduction or malfunctions in the circuit board 4, is prevented from being defined in the frame structure of the electrically conductive frame 44, and a gap, which may result in the box cover 19 and electrically the conductive frame 44 being unable to be tightly connected to each other, may be prevented from being defined in the electrically conductive rubber ring 5a. Moreover, the electrically conductive frame 44, the electrically conductive rubber ring 5a, and the isolation cavity 192 have a same cross-sectional cavity shape along a direction perpendicular to a depth direction of the isolation cavity 192. That is, when the isolation cavity 192, the electrically conductive rubber ring 5a and the electrically conductive frame 44 are vertically projected along a direction perpendicular to a top surface of the circuit board 4 on which the control module circuit area 41, the drive module circuit area 42 and the interface circuit area 43 are arranged, one same projection line of one same shape is obtained. In this way, the electrically conductive frame 44, the electrically conductive rubber ring 5a and the isolation cavity 192 can operate cooperatively with each other.

In an embodiment, as shown in FIG. 3, the electric drive controller of the present disclosure further includes a plug-connection member 6, and the plug-connection member 6 is configured to connect with corresponding plug connectors of other components of the entire vehicle to achieve electrical conduction. Specifically, the plug-connection member 6 includes a soldering pin 61 that is soldered and fixed to the circuit board 4 and connected to the interface circuit area 43. The plug-connection member 6 and the electrically conductive frame 44 are respectively disposed on two opposite sides of the circuit board 4. It is to be understood that, after the plug-connection member 6 being connected to the plug connectors of the other components, the plug-connection member 6 is connected to the circuit board 4 through the soldering pin 61 to be connected to the interface circuit area 43 to allow the electric drive controller to communicate with the other components. Moreover, the plug-connection member 6 further includes a plug-connection end 62 opposite to the soldering pin 61. At least part of the plug-connection end 62 extends to be exposed out of the box body 18. That is, he plug-connection member 6 may be arranged on and extend through a wall of the box body 18. In this case, a portion of the plug-connection end 62 is exposed out of the wall of the box body 18. In addition, the electric drive controller further includes a fixation member 7, the fixation member 7 fixes the circuit board 4 in the box body 18 by extending along a first direction to extend through the fixation holes 45 at the periphery of the circuit board 4.

In addition, in an embodiment, the electric drive controller of the present disclosure further includes a heat dissipation waterway plate 10a and a bus capacitor module 10b. The bus capacitor module assembly 10b is connected to the controller box 1. The heat dissipation waterway plate 10a is connected to the controller box 1 via screws. It is understood that the heat dissipation waterway plate 10a may dissipate heat from the bus capacitor module assembly 10b to take away a large amount of heat generated during the electric drive controller operating, preventing the electric drive controller from being damaged.

As shown in FIG. 5, FIG. 5 is a structural schematic view of an electric drive system according to an embodiment of the present disclosure, and the electric drive system includes a drive motor and the electric drive controller. In another aspect of the present disclosure, the electric drive system is provided and includes a drive motor 9 and the electric drive controller as described above. The drive motor 9 is connected to the electric drive controller. A structure of the electric drive controller has been described in detail above and will not be repeated herein.

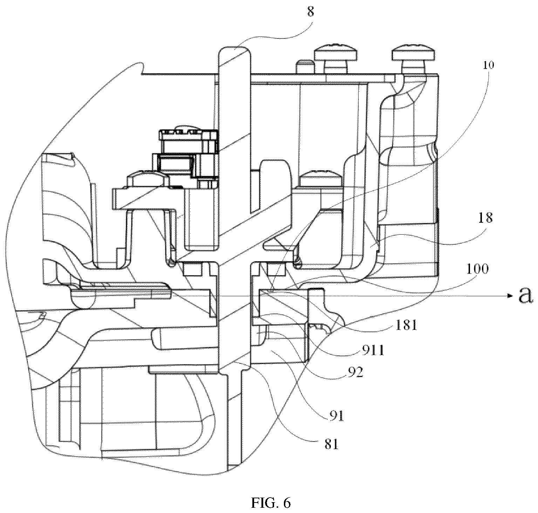

As shown in FIG. 6, FIG. 6 is a cross-sectional view of the electric drive system shown in FIG. 5, taken along a line B-B. In an embodiment, the electric drive controller includes a three-phase wire copper row 8 arranged in the controller box 1. The three-phase wire copper row 8 includes a connection end 81 exposed from the controller box 1, and that is, the connection end 81 extends from the three-phase wire copper row 8 towards the controller box 1 to be exposed out of the controller box 1 so as to be connected with other electronic components. The drive motor 9 includes a motor housing 91 and a motor terminal 92 exposed out of the motor housing 91. During assembling, the motor terminal 92 is connected to the connection end 81 of the three-phase wire copper row 8. Further, the box body 18 and the motor housing 91 support each other. A blocking member 10 is disposed in a gap path defined between the box body 18 and the motor housing 91, and the gap path extends along a direction from a connection point where the connection end 81 and the motor terminal 92 are connected to each other towards an exterior of the electric drive system (i.e., the direction indicated by an arrow line a in FIG. 6). The direction indicated by the arrow line a is pointing towards the exterior of the electric drive system. A direction away from the direction indicated by the arrow line a is a direction pointing towards an interior of the electric drive system. Moreover, the direction indicated by the arrow line a is a direction in which electromagnetic of the electric drive system radiates outwardly. It is understood that the connection point where the connection end 81 to the motor terminal 92 are connected to each other is located close to an inner side of an electromagnetic radiation path, and the blocking member 10 is located close to an outer side of the electromagnetic radiation path. Therefore, when the electromagnetic radiates outwardly from the connection point where the connection end 81 and the motor terminal 92 are connected to each other, the electromagnetic encounters the blocking member 10, and the blocking member 10 blocks the electromagnetic radiation. On the one hand, the electromagnetic, during radiating outwardly, encounters blocking and is weakened. On the other hand, the electromagnetic, during radiating outwardly from the connection point where the connection end 81 and the motor terminal 92 are connected to each other, needs to bypass the blocking member 10, such that the electromagnetic radiation path is extended, and a certain amount of radiation is reduced. In this way, the amount of electromagnetic, which is generated at the connection point where the electric drive controller and the drive motor 9 are connected to each other, radiating outwardly is prevented from exceeding a certain standard, and EMC leakage, which leads to EMC of the electric drive system failing to meet a standard, is prevented.

More specifically, each of the controller box 1 and the motor housing 91 includes a respective support surface 100, i.e., each of the box body 18 of the controller box 1 and the motor housing 91 is arranged with the respective support surface 100. The support surface 100 of the box body 18 and the support surface 100 of the motor housing 91 support and abut against each other. Since the support surface 100 of the box body 18 and the support surface 100 of the motor housing 91 support and abut against each other, a width of the gap path is effectively reduced, such that the amount of electromagnetic radiation is reduced. Understandably, a gap between the support surface 100 of the box body 18 and the support surface 100 of the motor housing 91 is the gap path, and the blocking member 10 is received in the gap path. The connection end 81 extends from the three-phase wire copper row 8 to be exposed out of the support surface 100 of the controller box 1. That is, the wall of the controller box 1 defines a structure similar to a through hole, such that the connection end 81 of the three-phase wire copper row 8 can extend outwardly. Further, the support surface 100 of the box body 18 is arranged with a protrusion 181. The support surface 100 of the motor housing 91 defines a recess 911. The protrusion 181 on the box body 18 is received in the recess 911 of the motor housing 91. The electric drive controller and the drive motor 9 can be positioned and snapped through mating between the protrusion 181 and the recess 911. Since the protrusion 181 is received in the recess 911, the protrusion 181 provides limiting to enable assembling between the electric drive controller and the drive motor 9 to be tighter. In this way, the electric drive controller and the drive motor 9 are prevented from being loosened from each other, such that the electromagnetic radiation generated, due to current conduction, at the connection point where the connection end 81 and the motor terminal 92 are connected to each other is prevented from exceeding the standard, and the EMC leakage, which leads to the EMC of the electric drive system failing to meet the standard, is prevented. In addition, when a plurality of recesses 911 and a plurality of protrusion 181 are provided, each the support surface 100 of the box body 18 and the support surface 100 of the motor housing 91 is a concave and convex surface, having a toothed structure, a wavy structure, or a pulsed structure.

As shown in FIG. 1, in some embodiments, the connection end 81 extends from the protrusion 181 to be exposed out of the box body 18. That is, the protrusion 181 and the recess 911 are disposed at the connection point where the connection end 81 and the motor terminal 92 are connected to each other. Of course, it is understood that, in some embodiments, the above-mentioned protrusion 181 and the recess 911 may be disposed at any position of the electromagnetic radiation path along which the electromagnetic radiates outwardly from the connection point where the connection end 81 with the motor terminal 92 are connected to each other. That is, the above-mentioned protrusion 181 and the recess 911 may be disposed at any position along the direction indicated by the arrow line a, taking the connection point where the connection end 81 with the motor terminal 92 are connected to each other as a starting point.

In still another aspect of the present disclosure, a vehicle is provided and includes a battery pack, a high-voltage bus line, and the electric drive controller as described above. The high-voltage bus line is connected to the interface end portion 21 of the battery pack and the electric drive controller to allow the battery pack to supply power to the electric drive controller. In this way, it is ensured that the electric drive controller operates normally. The structure of the electric drive controller has been described in detail above and will not be repeated herein.

In the description of the present disclosure, the terms "an embodiment", "some embodiments", "an example", "a specific example", or "some examples" mean that specific features, mechanisms, materials, or characteristics described in an embodiment or an example are included in at least one embodiment or example of the present disclosure. In the present specification, schematic expressions of the above terms do not necessarily refer to a same embodiment or example. Moreover, the specific features, mechanisms, materials, or characteristics described may be combined in any one or more embodiments or examples in any suitable manner. Furthermore, without contradicting each other, any ordinary skilled person in the art may combine different embodiments or examples and features of different embodiments or examples described in the present specification.

The above describes only the implementation of the present disclosure and does not limit the scope of the present disclosure. Any equivalent structure or equivalent process transformation performed based on the specification and the accompanying drawings of the present disclosure, applied directly or indirectly in other related technical fields, shall be included in the scope of the present disclosure.

## Claims

1. An electric drive controller, comprising a controller box and electronic components arranged in the controller box, wherein the electric drive controller is **characterized in that**,
the controller box comprises a closed cavity, a plug-connection hole and a cover body covering the closed cavity; the plug-connection hole is communicated with the closed cavity;
the electronic components comprise a high-voltage bus perforation connector, the high-voltage bus perforation connector comprises an interface end portion; and
the high-voltage bus perforation connector is received in the closed cavity, and the interface end portion is received in the plug-connection hole.

2. The electric drive controller according to claim 1, wherein, the controller box further comprises a receiving cavity, a connection hole and an isolation plate;
the receiving cavity and the closed cavity are communicated with each other via the connection hole, the isolation plate covers the connection hole, and the isolation plate defines a wire through hole;
the electronic components further comprise a filter assembly and a circuit board, the circuit board is received in the receiving cavity; the filter assembly is received in the receiving cavity and connected to the high-voltage bus perforation connector; and
the filter assembly comprises a connection end portion, the connection end portion is arranged within the wire through hole and connected to the circuit board.

3. The electric drive controller according to claim 2, wherein, an isolation sealing ring is arranged in the connection hole;
the isolation plate is mounted in the connection hole, the isolation sealing ring sleeves peripheral end edges of the isolation plate and abuts against a wall of the connection hole and the peripheral end edges of the isolation plate.

4. The electric drive controller according to claim 2, wherein, the controller box is arranged with a stop step formed at a connection position where the connection hole and the closed cavity are connected to each other; and
the isolation plate is fixed to the stop step and covers the connection hole.

5. The electric drive controller according to claim 4, wherein,
the controller box is arranged with another stop step at a connection position where the connection hole and the receiving cavity are connected to each other;
an isolation sealing ring is arranged in the connection hole;
the isolation plate comprises a first sub-plate and a second sub-plate, the first sub-plate is fixed to the stop step, the second sub-plate is fixed to the another stop step;
the isolation sealing ring is disposed between and abuts against the first sub-plate and the second sub-plate.

6. The electric drive controller according to claim 2, wherein,
the filter assembly further comprises a housing, the connection end portion is formed by extending from the housing; and
the isolation plate is a fixed flange protruding from the housing.

7. The electric drive controller according to claim 2, wherein, the circuit board is arranged with a control module circuit area and a drive module circuit area; and
the circuit board defines a plurality of fixation holes at a periphery of the circuit board, and the circuit board is fixedly arranged in the receiving cavity through the plurality of fixation holes.

8. The electric drive controller according to claim 7, wherein, the controller box comprises a box body and a box cover covering to the box body;
the closed cavity and the receiving cavity are both defined in the box body, the box cover defines a disassembling opening at a position corresponding to the closed cavity, the cover body covers the disassembling opening;
the circuit board is further arranged with an interface circuit area and an electrically conductive frame surrounding the interface circuit area;
the box cover further defines an isolation cavity at a position corresponding to the receiving cavity, the interface circuit area is disposed in the isolation cavity, and an end surface of the isolation cavity abuts against the electrically conductive frame.

9. The electric drive controller according to claim 8, wherein, an electrically conductive rubber ring is disposed between the isolation cavity and the electrically conductive frame;
the electrically conductive rubber ring abuts against the end surface of the isolation cavity and the electrically conductive frame;
each of the electrically conductive frame and the electrically conductive rubber ring is a closed frame structure where a head and an end of the frame structure are connected to each other;
the electrically conductive frame, the electrically conductive rubber ring and the isolation cavity have a same cross-sectional cavity shape along a direction perpendicular to a depth direction of the isolation cavity.

10. The electric drive controller according to claim 8, wherein the electric drive controller further comprises a plug-connection member and a fixation member;
the plug-connection member comprises a soldering pin, the soldering pin is soldered and fixed to the circuit board and connected to the interface circuit area;
the fixation member extends along a first direction to extend through the fixation hole to fix the circuit board in the box body; and
the plug-connection member further comprises a plug-connection end disposed opposite to the soldering pin, and at least part of the plug-connection end extends to be exposed out of the box body.

11. The electric drive controller according to claim 1, wherein the controller box comprises a box body and a box cover covering to the box body;
the box cover defines a disassembling opening at a position corresponding to the closed cavity, the box cover covers the disassembling opening;
the box cover is arranged with a tab protruding from the box cover, the tab is mated with the disassembling opening, the tab is received in the disassembling opening;
a sealing ring is arranged to sleeve an outer wall of the tab, the sealing ring is disposed between the tab and an inner wall of the disassembling opening.

12. An electric drive system, comprising a drive motor, wherein the electric drive system is **characterized in** further comprising the electric drive controller according to any one of claims 1 to 11, wherein the drive motor is connected to the electric drive controller.

13. The electric drive system according to claim 12, wherein, the electric drive controller comprises a three-phase wire copper row arranged in the controller box, the three-phase wire copper row comprises a connection end exposed out of the controller box;
the drive motor comprises a motor housing and a motor terminal exposed from the motor housing; the controller box and the motor housing support each other, and the connection end is connected with the motor terminal; and
a blocking member is received in a gap path defined between the controller box and the motor housing, and the gap path extends along a direction from a connection point where the connection end and the motor terminal are connected to each other towards an exterior of the electric drive system.

14. The electric drive system according to claim 13, wherein, each of the controller box and the motor housing comprises a respective support surface, the support surface of the controller box and the support surface of the motor housing support each other;
the connection end protrudes from the support surface of the controller box to be exposed out of the controller box;
the support surface of the controller box is arranged with a protrusion;
the support surface of the motor housing defines a recess, the protrusion is received in the recess.

15. A vehicle, comprising a battery pack and a high-voltage bus line, wherein the vehicle is **characterized in** further comprising the electric drive controller according to any one of claims 1 to 11, wherein the high-voltage bus line is connected to the battery pack and the interface end portion.
